# EUROPÄISCHE PATENTANMELDUNG

(11) **EP 0 883 169 A2**
(43) Veröffentlichungstag der Anmeldung: **09.12.1998**
(21) Anmeldenummer: 98108322.3
(22) Anmeldetag: 07.05.1998
(51) Int. Cl.: H01L 21/336, H01L 29/786

(54) **Verfahren zur Herstellung von einem Dünnschichttransistor**

(30) Priorität: 04.06.1997 DE 19723330
(71) Anmelder: ROBERT BOSCH GMBH, 70442 Stuttgart (DE)
(72) Erfinder: Glück, Joachim, Dr., 71272 Renningen (DE); Henke, Sascha, Dr., 70197 Stuttgart (DE)

(57) **Zusammenfassung**

Es wird ein Verfahren zur Herstellung von Dünnschichttransistoren mit einer Halbleiterschicht aus amorphem Silizium und Drain- und Source-Kontakten aus n-dotiertem amorphem Silizium vorgeschlagen, wobei zwischen die Halbleiterschicht und die n-dotierte amorphe Siliziumschicht für die Drain- und Source-Kontakte eine Ätzstoppschicht aus einem halbleitenden Material aufgebracht wird.

## Beschreibung

### Stand der Technik

Die Erfindung geht aus von einem Verfahren zur Herstellung von Dünnschichttransistoren und einem Dünnschichttransistor nach den Gattungen der unabhängigen Ansprüche.

Insbesondere zur Ansteuerung der Zellen von Flüssigkristallbildschirmen werden häufig Dünnschichttransistoren mit amorphem Silizium als Halbleiterkanal eingesetzt, da sich diese Transistoren durch eine ausreichend hohe Beweglichkeit und einen Sperrstrom von weniger als 1 pA auszeichnen. Die Drainund Source-Kontakte dieser Transistoren bestehen in aller Regel aus n-dotiertem amorphen Silizium. Die n-dotierte Halbleiterschicht kann dabei direkt auf die amorphe Halbleiterschicht aufgebracht und anschließend mit der darüberliegenden Kontaktmetallschicht in einem Ätzprozeß strukturiert werden. Hierbei tritt jedoch die Schwierigkeit auf, daß die n⁺-dotierte Siliziumschicht selektiv zur amorphen Silizium-Halbleiterschicht geätzt werden muß, was aufgrund der starken chemischen und physikalischen Verwandtschaft der beiden Materialien nahezu unmöglich ist, ohne daß dabei unerwünschte Anätzungen auch der Halbleiterschicht entstehen. Es wird daher häufig eine Ätzstoppschicht zwischen die Halbleiterschicht und die Schicht für die Drain- und Source-Kontakte aufgebracht, wobei für die Ätzstoppschicht ein Isolator, vorzugsweise Siliziumnitrid (SiNx) eingesetzt wird. Die SiNx-Schicht wird in einem PECVD-Prozeß (PECVD = plasma enhanced chemical vapor deposition) abgeschieden und anschließend in einem Fotolithografieschritt so strukturiert, daß nur der Bereich des Halbleiterkanals von der Ätzstoppschicht bedeckt ist, die Halbleiterschicht im Bereich der Drain- und Source-Kontakte jedoch frei liegt. Anschließend wird das n-dotierte Silizium abgeschieden und kann dann im Bereich des Halbleiterkanals selektiv gegenüber der Ätzstoppschicht geätzt werden. Durch Einfügen dieser Ätzstoppschicht wird zwar das Anätzen der empfindlichen Halbleiterschicht beim Strukturieren der Drain- und Source-Kontakte vermieden, doch bedeutet das Aufbringen der Ätzstoppschicht einen hohen fertigungstechnischen Aufwand mit zusätzlichen PECVD-, Lithografie- und Ätzschritten. Außerdem entsteht ein relativ hoher Übergangswiderstand zwischen der amorphen Silizium-Halbleiterschicht und dem n-dotierten Silizium im Bereich der Drain- und Source-Kontakte, da die beiden Schichten nicht in einem einzigen Vakuumschritt abgeschieden werden können.

### Vorteile der Erfindung

Das erfindungsgemäße Verfahren mit den kennzeichnenden Merkmalen des Anspruchs 1 hat gegenüber dem beschriebenen Stand der Technik den Vorteil, daß die Ätzstoppschicht nicht strukturiert zu werden braucht. Im Gegensatz zu Siliziumnitrid ist die erfindungsgemäße Ätzstoppschicht nicht isolierend sondern halbleitend. Sie kann deswegen ganzflächig aufgebracht werden und muß nicht im Bereich des Halbleiterkanals weggeätzt werden. Damit entfallen sämtliche Strukturierungsschritte für die Ätzstoppschicht. Das Herstellungsverfahren entfacht sich dadurch deutlich gegenüber herkömmlichen Verfahren mit Ätzstoppschichten und ermöglicht dennoch ein selektives Ätzen der n-dotierten Siliziumschicht gegenüber der amorphen Silizium-Halbleiterschicht.

Die in den beiden abhängigen Ansprüchen aufgeführten Maßnahmen sind vorteilhafte Weiterbildungen des in Anspruch 1 angegebenen erfindungsgemäßen Verfahrens. So kann als Ätzstoppschicht vorzugsweise mikrokristallines amorphes und undotiertes Silizium (µ-c-Si:H) aufgebracht werden. Als Halbleiterschicht kann i-a-Si:H und für die Drain- und Source-Kontakte eine n⁺-a-Si:H-Schicht aufgebracht werden. Das mikrokristalline amorphe Silizium weist eine höhere Dichte als n⁺-a-Si:H auf, wodurch sich die n⁺-a-Si:H-Schicht selektiv zur Ätzstoppschicht ätzen läßt. Die i-a-Si:H-Schicht, die µ-c-Si:H-Schicht und die n⁺-a-Si:H-Schicht können im gleichen Vakuum abgeschieden werden, so daß auch für das Aufbringen der Ätzstoppschicht kein gesonderter PECVD-Schritt erforderlich ist.

Der erfindungsgemäße Dünnschichttransistor weist eine Halbleiterschicht aus amorphem Silizium, eine darüber angeordnete weitere halbleitende Schicht und Drain- und Source-Kontakte aus n-dotiertem amorphem Silizium aus. Gemäß den abhängigen Ansprüchen kann die Halbleiterschicht vorteilhafterweise aus i-a-Si:H und die weitere halbleitende Schicht aus µ-c-Si:H bestehen. Außerdem kann der Dünnschichttransistor ein Gate-Dielektrikum aus SiNx sowie eine Kontaktmetallisierung aus Molybdän aufweisen.

### Zeichnung

Nachfolgend wird ein bevorzugtes Ausführungsbeispiel eines erfindungsgemäßen Verfahrens und Dünnschichttransistors anhand der Zeichnung näher beschrieben.

Es zeigen:
- Fig. 1: einen Querschnitt durch einen Dünnschichttransistor vor dem Strukturieren der Drain- und Source-Kontakte;
- Fig. 2: einen Querschnitt durch den Dünnschichttransistor nach Fig. 1 nach dem Strukturieren der Drain- und Source-Kontakte.

### Beschreibung

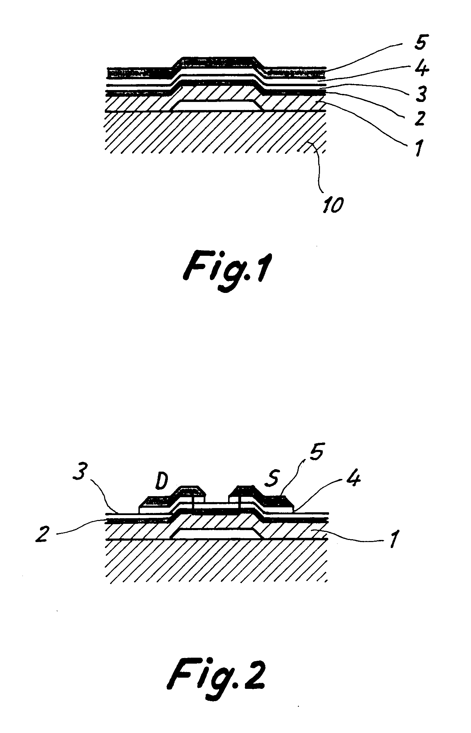

Gemäß Fig. 1 werden zur Herstellung eines Dünnschichttransistors auf einem Substrat 10 nacheinander eine Schicht 1 als Gate-Dielektrikum, beispielsweise Siliziumnitrid, dann eine Halbleiterschicht 2 aus undotiertem amorphem Silizium und anschließend eine Ätzstoppschicht aus einem zweiten halbleitenden Material, vorzugsweise aus mikrokristallinem, undotiertem amorphen Silizium aufgebracht, bevor n-dotiertes Silizium für die Drain- und Source-Kontakte D, S aufgebracht wird. Abschließend wird eine Kontaktmetallisierung 5, beispielsweise aus Molybdän, aufgebracht. Es folgt dann das Strukturieren der Drain- und Source-Kontakte in einem fotolithografischen Verfahren und anschließenden Ätzen, wodurch sich der in Fig. 2 gezeigte endgültige Aufbau des Dünnschichttransistors ergibt. Die Schichten 4 und 5 werden bis auf die Drain- und Source-Kontaktbereiche D, S weggeätzt, während die darunter befindliche Ätzstoppschicht ganzflächig erhalten bleibt. Diese Ätzstoppschicht 3 sorgt dafür, daß die empfindliche Halbleiterschicht 2 während des Ätzprozesses nicht mitangeätzt wird.

## Patentansprüche

1. Verfahren zur Herstellung von Dünnschichttransistoren mit einer Halbleiterschicht aus amorphem Silizium und Drain- und Source-Kontakten aus n-dotiertem amorphem Silizium, dadurch gekennzeichnet, daß zwischen die Halbleiterschicht (2) und die n-dotierte amorphe Siliziumschicht (4) für die Drain- und Source-Kontakte (D, S) eine Ätzstoppschicht (3) aus einem halbleitenden Material aufgebracht wird.

2. Verfahren nach Anspruch 1, dadurch gekennzeichnet, daß als Ätzstoppschicht (3) mikrokristallines amorphes und undotiertes Silizium (µ-c-Si:H) aufgebracht wird.

3. Verfahren nach Anspruch 1 oder 2, dadurch gekennzeichnet, daß als Halbleiterschicht (2) i-a-Si:H und als Drain- und Source-Kontakte (D, S) eine n⁺-a-Si:H-Schicht aufgebracht wird.

4. Verfahren nach Anspruch 2 und 3, dadurch gekennzeichnet, daß die i-a-Si:H-Schicht, die µ-c-Si:H-Schicht und die n⁺-a-Si:H-Schicht im gleichen Vakuum abgeschieden werden.

5. Dünnschichttransistor mit einer Halbleiterschicht (2) aus amorphem Silizium, einer darüber angeordneten weiteren halbleitenden Schicht (3) und Drain- und Source-Kontakten (D, S) aus n-dotiertem amorphem Silizium.

6. Dünnschichttransistor nach Anspruch 5, dadurch gekennzeichnet, daß die Halbleiterschicht (2) aus i-a-Si:H und die weitere halbleitende Schicht aus µ-c-Si:H besteht.

7. Dünnschichttransistor nach Anspruch 5 oder 6, dadurch gekennzeichnet, daß er ein Gate-Dielektrikum (6) aus SiNx aufweist.

8. Dünnschichttransistor nach einem der Ansprüche 5 bis 7, dadurch gekennzeichnet, daß er Kontaktmetallisierungen (5) aus Molybdän aufweist.
